# FASCICULE DE BREVET EUROPEEN

(11) **EP 1 825 510 B1**
(45) Date de publication et mention de la délivrance du brevet: **15.07.2009**
(21) Numéro de dépôt: 05815827.0
(22) Date de dépôt: 08.12.2005
(51) Int. Cl.: H01L 23/02

(54) **PROCEDE DE FABRICATION COLLECTIVE DE MICROSTRUCTURES A ELEMENTS SUPERPOSES**
VERFAHREN ZUM KOLLEKTIVEN PRODUZIEREN EINER ELEMENTÜBERLAGERUNGS-MIKROSTRUKTUR
METHOD FOR COLLECTIVELY PRODUCING A SUPERIMPOSED ELEMENT MICROSTRUCTURE

(30) Priorité: 15.12.2004 FR 0413345
(43) Date de publication de la demande: 29.08.2007
(73) Titulaire: E2V Semiconductors, 38120 Saint Egreve (FR); Tracit Technologies, 38190 Bernin (FR)
(72) Inventeur: ROMMEVEAUX, Philippe, F-38500 COUBLEVIE (FR); ASPAR, Bernard, F-38140 RIVES (FR)
(74) Mandataire: Guérin, Michel
(86) Numéro de dépôt international: PCT/EP2005/056599
(87) Numéro de publication internationale: WO 2006/063961

(56) Documents cités:
- WO-A-20/04008522
- US-A- 5 668 033
- US-A1- 2002 170 175
- US-B1- 6 407 381
- US-B1- 6 555 901

## Description

L'invention concerne d'une manière générale la fabrication collective de micro-structures collées superposées et elle s'applique notamment à la fabrication de circuits électroniques intégrés, et, par extension, de structures micro-usinées fabriquées selon des procédés collectifs analogues à ceux qui sont employés dans la fabrication des circuits électroniques intégrés. Ces structures micro-usinées sont connues sous l'appellation MEMS quand elles intègrent des fonctions électriques et mécaniques (par exemple des microcapteurs de pression, d'accélération, etc.) et MOEMS quand elles intègrent des fonctions électriques et optiques (capteurs d'image, afficheurs).

Pour mieux faire comprendre l'invention, et à titre d'exemple seulement, on décrira plus précisément l'application à la fabrication d'un capteur d'image électronique ; un capteur d'image électronique est typiquement destiné par exemple à former le coeur d'un appareil de photographie numérique ou d'une caméra numérique ; il convertit en signaux électriques une image projetée sur sa surface sensible.

Le capteur d'image est classiquement un circuit intégré électronique monolithique formé sur un substrat de silicium ; à la surface de ce substrat sont formés d'une part une matrice de photodétecteurs et d'autre part des circuits électroniques périphériques ; les circuits périphériques servent à la commande de la matrice et à l'extraction et au traitement des signaux qui sont issus de la matrice et qui représentent sous forme électronique l'image projetée par un objectif sur la matrice.

Le circuit intégré monolithique est donc destiné à être associé, dans l'appareil de photographie, à une optique de projection (une lentille ou plusieurs lentilles superposées) qui projette l'image à détecter sur la surface photosensible de la matrice. Cette optique de projection peut faire partie du capteur, c'est-à-dire être intégrée avec le capteur devant la surface supérieure de celui-ci, ou être séparée et faire partie de l'appareil de photographie. Mais même si elle est séparée, il peut être utile de prévoir sur le capteur lui-même un autre élément optique tel qu'une plaquette transparente de protection ou de filtrage optique, montée directement sur le capteur lors de la fabrication de celui-ci. C'est le cas non seulement pour la photographie dans le domaine visible, mais c'est le cas aussi par exemple dans le domaine de l'imagerie à rayons X, où il peut être souhaitable de monter sur le capteur, à la fabrication de celui-ci, une plaquette de matériau scintillateur, et éventuellement une galette de fibres optiques entre le scintillateur et la matrice de photodétecteurs.

On peut ainsi donner des exemples dans lesquels il est utile d'associer à un circuit intégré à fonctions électroniques une structure mécanique ou optique qui ne fait pas partie au départ du même substrat que le circuit intégré proprement dit mais qui doit être rapportée sur ce substrat lors de la fabrication de celui-ci. L'exemple le plus simple est la plaquette transparente sur un capteur d'image, et on continuera l'explication à propos de ce cas simple, mais l'invention s'applique aux autres structures mentionnées ci-dessus (lentilles, galette de fibres etc.) ou même un simple capot de protection transparent ou non, ou une superposition de plaques de circuits électroniques. On va voir que ce report d'une plaque de protection ou d'une autre structure sur le circuit intégré a posé jusqu'à maintenant des problèmes, et la présente invention se propose d'aider à résoudre ces problèmes.

De manière classique, la fabrication d'un circuit intégré se fait collectivement à partir d'une tranche (en anglais "wafer") de silicium : on forme sur cette tranche, par des opérations successives de dépôt de couches, de photolithographie de ces couches, et de gravures chimiques ou ioniques, une multiplicité de circuits intégrés individuels identiques, agencés en réseau de lignes et de colonnes ; puis on découpe la tranche en "puces" individuelles correspondant chacune à un seul circuit intégré. Chaque puce est ultérieurement montée dans un boîtier individuel.

Lorsqu'il faut rapporter sur la face avant du circuit intégré, avant montage en boîtier individuel, une plaquette de verre transparente, cette plaquette est d'abord coupée aux dimensions désirées (un peu plus petites que celles de la puce elle-même) puis elle est collée sur la face supérieure de la puce. Dans ce qui suit on appellera "face supérieure" ou "face avant" de la puce ou du substrat la face à partir de laquelle sont formés par dépôts et gravures successifs les motifs de circuit définissant les fonctions électroniques du capteur d'image. Parmi ces motifs, il y a des plots de contact permettant la connexion électrique avec l'extérieur du capteur, pour la commande du capteur et le recueil des signaux représentant l'image ; ces plots sont situés à la périphérie de la puce ; ils doivent rester accessibles pour pouvoir être soudés à des broches de connexion du boîtier ; c'est la raison pour laquelle la plaquette de verre transparente est coupée à des dimensions plus petites que la surface de la puce : les plots à la périphérie de la puce ne doivent pas être recouverts par la plaquette de verre.

Cette technique de fabrication impose que la plaquette transparente soit collée individuellement sur chaque puce ; l'étape de collage n'est donc pas collective pour l'ensemble d'une tranche de multiples puces ; pour réduire le coût de fabrication, il serait souhaitable que cette étape soit collective ; de plus, si l'étape de collage est collectivement faite avant la découpe, la plaque transparente protège la puce contre les poussières issues de la découpe, ce qui n'est pas le cas lorsque le collage n'est fait qu'après la découpe.

Mais une technique de fabrication collective se heurte a priori à une difficulté : si on colle une plaque de verre sur la tranche, cette plaque de verre vient recouvrir la totalité des puces, c'est-à-dire non seulement la matrice photosensible et ses circuits périphériques, mais aussi les plots de contact, ce qui rend difficile l'accès à ces derniers.

Des techniques de fabrication collective permettant de résoudre cette difficulté ont déjà été imaginées. Ainsi, le brevet US 6 040 235 propose une technique consistant à faire, après collage de la plaque transparente, une tranchée à flancs obliques venant couper les plots, puis un dépôt métallique dans cette tranchée, en contact avec la partie coupée des plots ; ce dépôt dans la tranchée remonte sur la face supérieure de la plaque pour y constituer de nouveaux plots ; ces derniers sont accessibles. Cette technique est complexe, elle utilise des étapes de procédé non classiques en microélectronique et l'établissement de contacts à l'intérieur de la tranchée n'est pas facile.

Une autre technique consiste à faire en sorte que les plots de contact soient situés sur la face arrière de la puce tout en étant reliés, à travers l'épaisseur de la tranche semiconductrice, aux circuits formés sur la face avant de celle-ci ; cette technique a été utilisée notamment pour des capteurs d'image à substrat semiconducteur aminci ; mais le passage de contacts de la face avant du substrat (face sur laquelle sont établis tous les éléments du circuit intégré) à la face arrière est difficile et oblige d'une part à des gravures profondes et d'autre part à des traitements de dépôts et gravure sur les deux faces du substrat, ce qui n'est pas souhaitable.

Dans le domaine particulier des senseurs d'éectromécanique micro-usinée, pour des accéléromètres par exemple, on a aussi proposé différentes techniques de collage de deux plaques de silicium, comme par exemple dans le brevet US 5 668 033. Mais ces technique sont complexes car elles exigent une texturation particulière des deux plaques avant leur mise en contact.

Le document US-A-6407381 décrit un procédé de fabrication d'un emballage pour microstructures comportant le collage de deux plaques. La première plaque est le substrat et comporte un réseau d'éléments électronique protégé par une couche de protection isolantes sur laquelle la deuxième plaque est collée pour former un couvercle. Les plaques sont découpées pour former les structures individuelles par deux opérations de découpes, l'une sur le substrat et l'autre sur le couvercle ou les découpes sont non superposées.

Il existe donc un besoin pour une fabrication collective plus simple de puces à partir d'une tranche, qui permette de coller collectivement une plaque sur la face avant de la tranche, en autorisant cependant un accès électrique à des contacts du capteur par la face avant de ce dernier après division de la tranche en multiples puces.

En résumé, on propose selon l'invention un procédé de fabrication collective de structures individuelles comportant chacune un premier élément et un second élément superposés ; les premiers éléments sont préparés sur une première structure collective ; les deuxièmes éléments sont préparés sur une deuxième structure collective ; les structures collectives sont collées l'une contre l'autre sur la majeure partie de leurs surfaces en regard, mais leurs surfaces ont été préalablement préparées de manière à définir des zones limitées où il n'y aura pas d'adhérence ; les structures individuelles sont ensuite découpées par le haut d'une part et par le bas d'autre part selon des lignes de découpe parallèles différentes, passant dans les zones sans adhérence, de manière qu'après découpe les premiers éléments conservent des portions de surface (celles situées entre les lignes de découpe parallèle) non recouvertes par un second élément.

Plus précisément, on propose selon l'invention un procédé de fabrication collective de structures à deux éléments superposés collés l'un à l'autre, à partir de deux plaques dont l'une comprend un réseau de premiers éléments sur lesquels doivent être collés des deuxièmes éléments appartenant à la deuxième plaque, la première plaque comportant des éléments de circuiterie électronique protégés par une couche de protection isolante, le procédé comprenant les opérations suivantes :
- collage de la face inférieure de la deuxième plaque sur la face supérieure de la première plaque, sur la majeure partie de leurs surfaces respectives, en excluant du collage des zones dites chemins de découpe formées par gravure de renfoncements dans la couche de protection isolante de la première plaque ;
- découpe des plaques en structures individuelles à deux éléments superposés comprenant un élément de plaque inférieur et un élément de plaque supérieur, les opérations de découpe comportant au moins une découpe d'un élément de la deuxième plaque par le côté de sa face supérieure selon une première ligne de découpe passant dans un chemin de découpe, et une découpe d'un élément de la première plaque, situé sous l'élément de la deuxième plaque, par le côté de sa face inférieure selon une deuxième ligne de découpe passant dans le même chemin de découpe mais non superposée à la première ligne de découpe, de sorte qu'une partie de l'élément de plaque inférieur, située entre les deux lignes de découpe, ne soit pas recouverte par l'élément de plaque supérieur qui est collé sur le premier élément.

Les appellations plaque supérieure et plaque inférieure ou face supérieure et face inférieure n'impliquent pas de fonctionnalité particulière de ces plaques ou de ces faces, ces dernières pouvant être actives ou passives.

L'élément de plaque inférieur peut alors comporter, sur sa face supérieure et dans cette partie non recouverte, un contact électrique d'accès à la structure (ou plusieurs contacts), l'écartement latéral entre les deux lignes de découpe étant supérieur à la largeur de ce contact (typiquement la largeur d'un plot de contact de circuit intégré est de plusieurs dizaines de micromètres et l'écart latéral entre lignes de découpe peut être d'au moins une centaine de micromètres) ; si l'élément de plaque inférieure est une puce de circuit intégré, le contact est sur la face avant de la puce, c'est-à-dire la face à partir de laquelle ont été effectués les dépôts et gravures des circuits électroniques de la puce.

Les éléments de la première plaque peuvent être des circuits électroniques intégrés ayant n'importe quelle fonction électronique ; la structure à deux éléments superposés est une structure purement électronique ou optoélectronique ou une structure micro-usinée ayant à la fois des fonctions mécaniques et électroniques (MEMS) ou encore des fonctions optiques (MOEMS). Les éléments de la deuxième plaque peuvent être des éléments optiques à associer aux éléments de la première plaque : soit de simples plaquettes de protection transparentes, soit des plaquettes ayant des fonctions plus sophistiquées (filtrage, mosaïques de filtres de couleur, lentilles, réseaux de microlentilles, galettes de fibres optiques, structures scintillatrices avec ou sans galette de fibres pour l'imagerie à rayons X, etc;).

Dans le cas de la fabrication d'un capteur d'image ou d'un afficheur d'image comprenant une puce de circuit intégré recouverte d'une structure optique individuelle, on comprend que le premier élément est la puce de capteur ou d'afficheur, la première plaque est une tranche semiconductrice sur laquelle on a formé un réseau de puces identiques disposées en lignes et en colonnes ; la deuxième plaque peut être une simple plaque transparente ; elle ne comporte pas nécessairement de motifs gravés ; ou bien la deuxième plaque peut, comme on le verra plus loin, comporter des motifs individuels gravés disposés avec la même périodicité en ligne et en colonne que les puces de la tranche semiconductrice.

Typiquement, les chemins de découpe ont une largeur de quelques centaines de micromètres, pour des plots de quelques dizaines de micromètres de large ; les puces ont plusieurs millimètres de côté, typiquement cinq à dix.

Le collage peut être un collage avec apport de matière de collage (colle, brasure) ou un collage sans apport de matière ; notamment il est très intéressant d'utiliser un collage direct, par simple adhérence moléculaire entre deux surfaces très planes, propres et de faible rugosité : si les surfaces sont très planes et assez étendues, la force d'adhérence entre les plaques est très élevée, surtout après une opération de recuit. Les zones non collées sont définies simplement dans ce cas par des renfoncements sur la surface de l'une des plaques (ou les deux) ; les surfaces de la première et de la deuxième plaque sont en contact presque partout mais ne sont pas en contact dans les renfoncements de sorte que l'adhérence entre les plaques se produit partout sauf dans les zones comportant les renfoncements. Le collage peut se faire aussi par soudure thermique, soudure anodique, fusion, etc.

La découpe le long des chemins de découpe se fait en principe par une scie mécanique, mais on peut envisager aussi des découpes par laser, par gravure chimique, par gravure par plasma, par électro-érosion, etc.

La découpe de la première plaque se fait en principe, pour chaque chemin de découpe, selon une seule ligne de découpe fine passant dans le chemin de découpe entre deux rangées de puces . La largeur de la ligne de découpe, c'est-à-dire la largeur de la lame de scie si c'est une scie qui fait la découpe, est faible, typiquement d'environ 30 à 50 micromètres de large.

Mais sur la deuxième plaque plusieurs possibilités existent :
- découpe selon une seule ligne de découpe fine passant dans le chemin de découpe entre deux rangées de puces, cette ligne étant parallèle à (mais ne se superposant pas à) la ligne de découpe de la première plaque ;
- ou bien découpe selon deux lignes de découpe fines parallèles passant dans le chemin de découpe entre deux rangées de puces, ces lignes étant parallèles à la ligne de découpe de la première plaque mais l'une au moins ne se superposant pas à cette dernière ; dans ce deuxième cas, la partie située entre les deux lignes de découpe de la deuxième plaque est un déchet qui est enlevé et qui ne fait pas partie de la structure finale à deux éléments superposés ;
- ou bien encore découpe de la deuxième plaque selon une largeur de trait plus importante que la largeur de la ligne de découpe fine de la première plaque ; dans ce cas on considère que ce trait comporte selon l'invention au moins un bord qui est décalé latéralement par rapport à la ligne de découpe de la première plaque, et c'est ce bord qui constitue la ligne de découpe de deuxième plaque non superposée à la ligne de découpe de la première plaque ; là encore, après découpe, l'élément de la première plaque comporte une partie non recouverte par l'élément de deuxième plaque qui est collé sur lui ; cette partie non recouverte contient au moins un plot de connexion extérieure.

D'autres caractéristiques de l'invention apparaîtront à la lecture de la description détaillée qui suit et qui est faite en référence aux dessins annexés dans lesquels :
- la figure 1 représente une tranche de silicium vue de dessus dans deux configurations de plots de contact des puces individuelles de la tranche ;
- la figure 2 représente la tranche de silicium en coupe, en vue agrandie ;
- la figure 3 représente l'ensemble superposé de la tranche et d'une plaque de verre transparente collée par adhérence moléculaire ;
- la figure 4 représente les lignes de découpe supérieures et inférieures de l'ensemble superposé ;
- la figure 5 représente les structures superposées individuelles résultant de la découpe ;
- la figure 6 représente le montage d'une structure sur un boîtier avec une connexion électrique entre la structure et le boîtier ;
- la figure 7 représente une découpe de la plaque supérieure par un trait de découpe large englobant les plots de contact ;
- la figure 8 représente les structures superposées individuelles qui en résultent ;
- la figure 9 représente l'ensemble superposé d'une tranche semiconductrice et d'une plaque de protection, avec les lignes de découpe correspondantes, dans le cas d'une puce électronique ayant des plots de contact sur deux côtés opposés de la puce ;
- la figure 10 représente les structures individuelles résultant de la découpe de l'ensemble de la figure 7 ;
- la figure 11 représente une découpe avec un trait de découpe large ;
- la figure 12 représente les deux plaques avec des chemins de découpe définis par des renfoncements dans la plaque supérieure ;
- la figure 13 représente les deux plaques avec des chemins de découpe définis par des renfoncements ayant deux niveaux de profondeur.

L'invention sera décrite de manière détaillée à propos d'un exemple simple qui est un capteur d'image formé par une puce de silicium recouverte d'une plaquette de verre transparente, la plaquette de verre laissant accessible les plots de contact de la puce en vue de permettre des liaisons électriques entre la puce et l'extérieur du capteur. L'invention n'est cependant pas limitée à cet exemple particulier.

On part d'une tranche semiconductrice (en principe du silicium monocristallin) sur laquelle on fabrique par des procédés classiques de dépôts et photogravures un réseau de puces identiques, en lignes et en colonnes, correspondant chacune à un capteur d'image respectif. L'indice n est affecté à une puce de rang n du réseau, l'indice n-1 à une puce adjacente d'un côté et l'indice n+1 à une puce adjacente de l'autre côté. Chaque puce Pₙ possède une zone active ZAₙ comportant une matrice d'éléments photosensibles et des circuits électroniques associés. A la périphérie de cette zone active et à l'extérieur de celle-ci sont disposés des plots de contact conducteurs PLₙ, qui seront ultérieurement connectés, après découpage de la tranche en puces individuelles et lors de l'encapsulation de la puce dans un boîtier de protection, à des bornes du boîtier. La connexion entre les plots de contact et les bornes extérieures se fait généralement par des fils d'or ou d'aluminium soudés d'un côté sur les plots de contact et de l'autre sur le boîtier.

La distinction qui est faite ici entre zone active et zone contenant des plots de contact n'implique pas bien entendu qu'il n'y a aucun élément actif en dehors de la zone active. Cette distinction est faite seulement pour distinguer une zone qui contient des plots de connexion extérieure d'une zone qui n'en contient pas, la zone qui contient des plots étant située à la périphérie de la zone qui n'en contient pas.

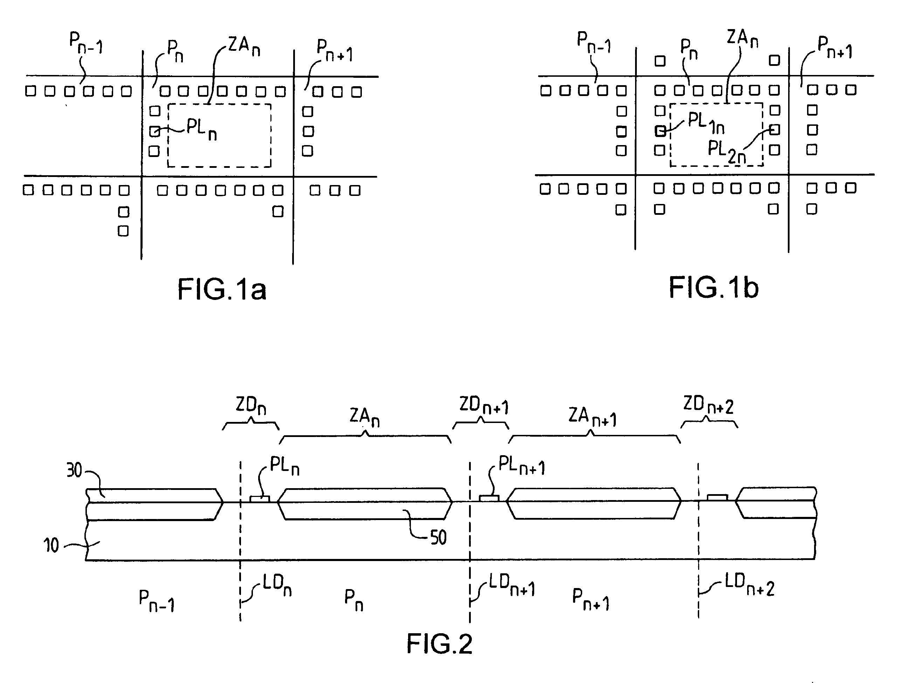

Les plots de contact peuvent être disposés sur un ou plusieurs côtés de la puce. Sur la figure 1A, les plots sont disposés seulement sur deux côtés adjacents de la puce, mais pas sur deux côtés opposés. Sur la figure 1B, les plots sont disposés au moins sur deux côtés opposés de la puce, de sorte que des plots PL1ₙ de la puce Pₙ sont en vis-à-vis de plots de la puce Pₙ₋₁ le long d'un côté qui sépare la puce Pₙ de la puce Pₙ₋₁, et de la même manière, sur le côté opposé, des plots PL2ₙ de la puce Pₙ sont en vis-à-vis de plots de la puce Pₙ₊₁ le long d'un côté qui sépare la puce Pₙ de la puce Pₙ₊₁ ; à titre d'exemple, on a représenté sur la figure 1b des plots sur trois côtés de la puce. Le procédé de fabrication dépend de la disposition des plots comme on va le voir.

La figure 2 représente en vue agrandie une coupe de la tranche de silicium 10 avec des puces juxtaposées ayant des plots sur un seul côté ou sur deux côtés adjacents mais pas sur deux côtés opposés. Comme à la figure 1, les puces adjacentes sont désignées par Pₙ₋₁, Pₙ, Pₙ₊₁ et la zone active de la puce Pₙ est désignée par ZAₙ ; un plot de contact PLₙ, situé en dehors de la zone active, est représenté schématiquement. Le détail des motifs de la zone active n'est bien sûr pas représenté ; ces motifs peuvent contenir des centaines de milliers d'éléments de circuit, réalisés essentiellement par des opérations classiques de dépôts de couches isolantes, semiconductrices et conductrices sur la face avant de la tranche (face supérieure située au-dessus sur la figure 2), et photogravures de ces couches. Pour simplifier la représentation, les circuits de chaque zone active sont schématisés sur la figure 2 par un rectangle 50 respectif.

Après fabrication des capteurs, on peut effectuer ce qu'on appelle une planarisation de la surface de la tranche. En effet, les opérations de dépôts et gravures de couches diverses, conductrices, isolantes ou semiconductrices, ont créé un relief sur la tranche (non visible sur la figure 2) et ce relief est de préférence éliminé autant que possible pour aboutir à une surface de tranche aussi plane que possible sur la majeure partie de sa surface ; l'opération de planarisation consiste en pratique essentiellement à recouvrir la tranche d'une couche de protection 30 (en général en silice) de quelques micromètres d'épaisseur qui comble les creux du relief, puis à graver uniformément cette couche pour en laisser seulement une épaisseur désirée, choisie pour assurer une protection suffisante du capteur contre les agressions de l'environnement extérieur. Une planarisation n'est pas obligatoire, mais on déposera en général une couche isolante telle que 30 sur la surface de la tranche, et dans ce qui suit on appellera cette couche "couche de planarisation".

De manière classique, avant ou après l'opération de planarisation, des ouvertures sont pratiquées dans la couche 30 pour dénuder au moins le centre des plots de contact et les rendre ainsi accessibles pour une soudure ultérieure de fil conducteur. Cependant, dans l'invention, on va pratiquer des ouvertures plus larges, englobant les plots de contact mais aussi des zones adjacentes aux plots de contact. Plus précisément, ces ouvertures s'étendent sur toute la largeur de zones qu'on appellera "chemins de découpe", occupant l'espace séparant la zone active ZAₙ d'une puce Pₙ et la zone active ZAₙ₋₁ou ZAₙ₊₁ d'une puce adjacente. Le chemin de découpe entre les puces Pₙ₋₁ et Pₙ est désigné par ZDₙ.

Les lignes pointillées de la figure 2 représentent des lignes de découpe LDₙ, LDₙ₊₁, LDₙ₊₂ selon lesquels la tranche est découpée pour être divisée en puces individuelles. L'épaisseur des traits de découpe est considérée comme négligeable sur la figure 2 ; en pratique ils font environ 30 à 50 micromètres de large. Les lignes de découpe LDₙ passent à l'intérieur des chemins de découpe ZDₙ, entre les plots PLₙ d'une puce Pₙ et la zone active de la puce adjacente PLₙ₋₁. Il faut imaginer ces lignes de découpe comme la lame filaire d'une scie verticale qui se déplacerait en avançant le long d'un chemin de découpe ; les chemins de découpe sont en pratique des bandes perpendiculaires situées entre les rangées et entre les colonnes de puces d'un réseau régulier.

La couche de planarisation est enlevée complètement dans les chemins de découpe.

La tranche fabriquée au stade de la figure 2 comporte donc des puces, des plots, des zones actives, et des chemins de découpe situés entre les zones actives de puces adjacentes. Les zones actives sont recouvertes d'une couche de protection plane ; les chemins de découpe englobent les plots et sont dénudés par enlèvement local de la couche de planarisation 30 pour mettre à nu les plots ; les plans de la découpe ultérieure passeront à l'intérieur des chemins de découpe, entre les plots d'une puce et les zones actives d'une puce adjacente.

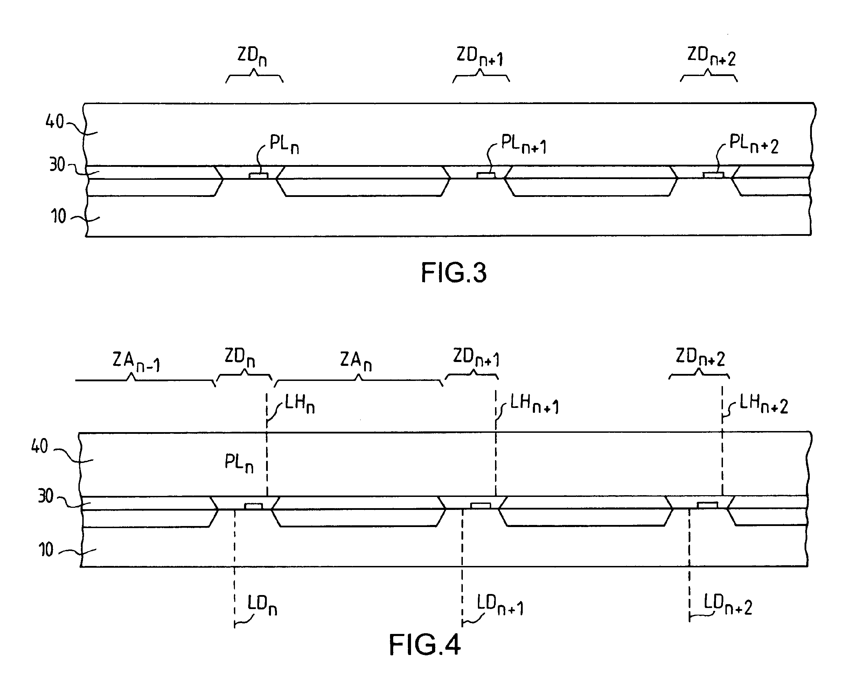

La figure 3 représente l'étape suivante de la fabrication. Pour protéger la puce ou pour assurer une autre fonction optique, on recouvre la tranche d'une plaque qui correspond à cette fonction de protection ou cette fonction optique. Dans cet exemple, il s'agit simplement d'une plaque de verre transparente 40 d'épaisseur uniforme, mais on comprend que la plaque peut être préparée avec un motif de fonctions (optiques par exemple) en correspondance avec le motif de puces préparé sur la tranche semiconductrice. L'épaisseur de la plaque est par exemple de l'ordre de 1 mm.

La surface inférieure de la plaque de verre 40 et la surface supérieure de la tranche 10 sont extrêmement planes et elles peuvent être collées directement l'une à l'autre par adhérence moléculaire. Le collage par adhérence moléculaire est avantageux en ce qu'il ne nécessite pas d'apport de matière de collage risquant de déborder dans les chemins de découpe et surtout sur les plots, et ne supportant pas des températures supérieures à 200°C. L'adhérence se produit sur la presque totalité de ces surfaces, mais il n'y a pas adhérence dans les chemins de découpe ZD du fait que ceux-ci, étant renfoncés par rapport à la surface de la couche de planarisation 30, ne sont pas en contact avec la plaque. On notera à ce stade que l'on peut aussi prévoir des renfoncements sur la plaque de verre plutôt que sur la tranche de silicium, dans les mêmes zones qui sont les chemins de découpe, et obtenir le même résultat d'absence d'adhérence dans ces zones ; toutefois cela nécessite ensuite d'aligner exactement les chemins de découpe gravés dans la plaque de verre avec les puces à découper sur la tranche et cette solution n'évite pas la gravure de la couche de planarisation puisqu'il faut de toutes façons dénuder les plots de contact.

La figure 4 représente les lignes de découpe de la structure collée ainsi formée. Il y a deux lignes de découpe dans chaque zone de découpe ZDₙ, la ligne de découpe déjà mentionnée LDₙ de la tranche semiconductrice inférieure et une ligne de découpe LHₙ de la plaque supérieure. Ces lignes sont toutes deux dans le chemin de découpe mais décalées latéralement l'une par rapport à l'autre. La ligne de découpe LDₙ de la tranche 10 passe comme on l'a dit entre la zone active ZAₙ₋₁ de la puce Pₙ₋₁ et les plots PLₙ de la puce Pₙ ; la ligne de découpe LHₙ de la plaque supérieure 40 passe entre le plot PLₙ et la zone active ZAₙ de la même puce Pₙ. L'écart entre les lignes est supérieur à la largeur d'un plot de contact.

La découpe selon la ligne de découpe LHₙ se fait à partir de la face supérieure de la plaque supérieure ; la découpe selon la ligne LDₙ se fait à partir de la face inférieure de la plaque inférieure.

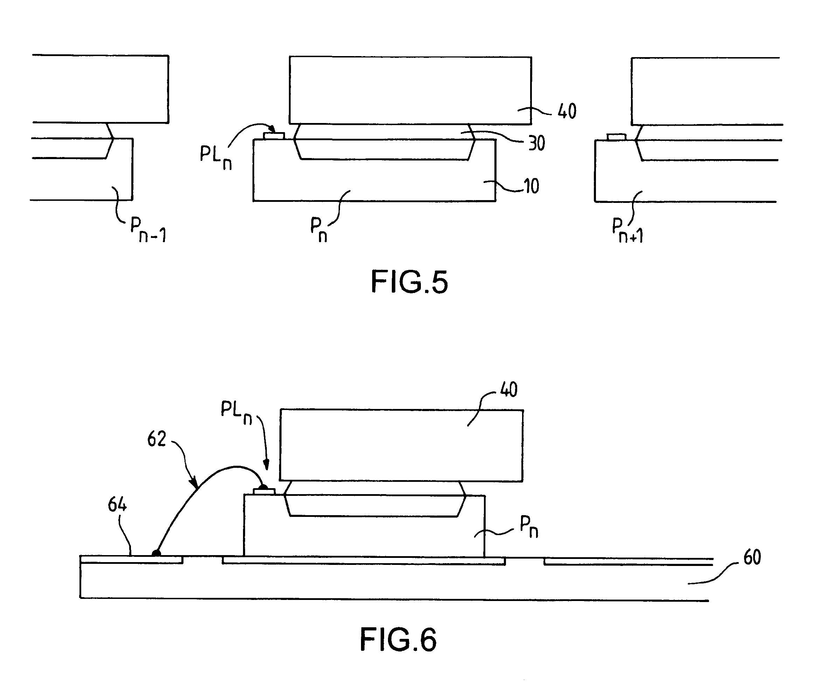

La figure 5 représente les structures superposées d'une puce (élément de plaque inférieur) et d'une plaquette de verre (élément de plaque supérieur) qui résultent de cette double découpe. La plaquette transparente recouvre l'essentiel de la surface supérieure de la puce et adhère fortement à toute cette surface sauf dans la partie qui correspondait au chemin de découpe. Les plots PLₙ sont complètement accessibles, n'étant recouverts ni par la plaquette de verre 40 ni par la couche de planarisation 30.

Du côté de la puce qui ne comporte pas les plots PLₙ ( côté droit de la puce sur la figure 5), la plaquette de verre déborde de la puce.

La figure 6 représente le montage de la puce, protégée par sa plaquette transparente, sur une embase 60 de boîtier d'encapsulation. La puce est collée par sa face inférieure à l'embase (en général sur une surface conductrice prévue sur l'embase), et des fils conducteurs 62 sont soudés selon la technique classique dite "wire-bonding" entre les plots PLₙ de la puce et des plots correspondants 64 aménagés sur l'embase, ces derniers plots étant en principe reliés à des broches de connexion extérieure du composant ainsi réalisé.

Dans l'exemple des figures 4 à 6, on a considéré que les lignes de découpe étaient obtenues par une scie (ou un autre instrument de découpe) aboutissant à une largeur de découpe très fine (inférieure à 50 micromètres) et en tous cas plus petite que la largeur des plots de contact qu'on veut laisser apparents sur l'élément de plaque inférieure.

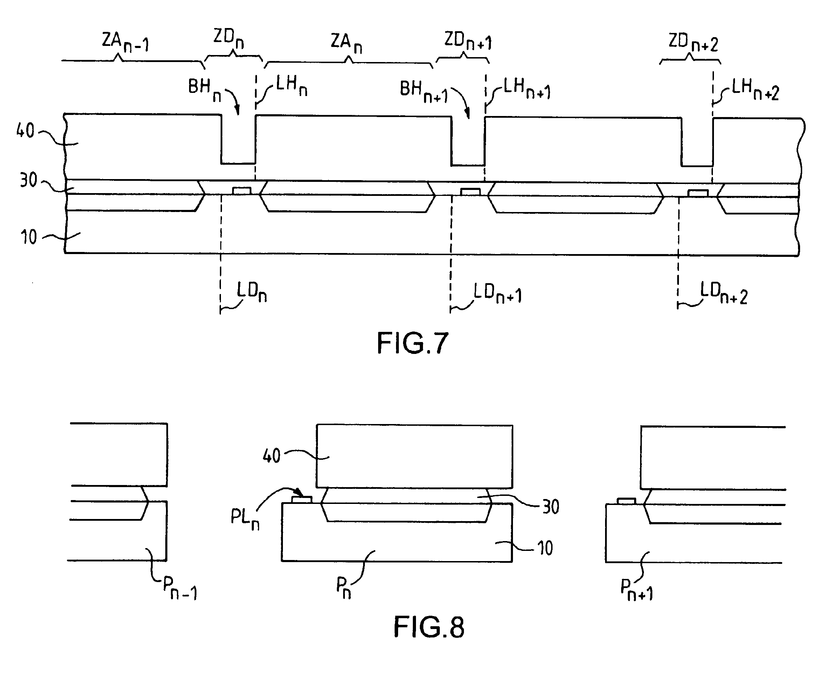

A la figure 7, on a représenté une autre manière de procéder, qui consiste à utiliser une lame de scie (ou un autre instrument de découpe) de largeur plus importante, à peu près égale à la largeur de la partie qu'on veut laisser découverte sur l'élément de plaque inférieure. La figure 7 représente l'amorce de découpe résultant de l'utilisation d'un trait de découpe large. La ligne de découpe fine LDₙ de la plaque inférieure n'est pas modifiée. La bande large de découpe, BHₙ de la plaque supérieure, comporte d'un côté un bord qui est constitué par la même ligne de découpe LHₙ que dans le cas de la figure 4 et qui est décalé latéralement par rapport à la ligne LDₙ, et de l'autre un bord LH'ₙ qui est ou qui n'est pas décalé par rapport à la ligne LDₙ. Dans ce cas, la bande de découpe BHₙ entre les lignes de découpe LHₙ et LH'ₙ recouvre les plots de contact qui doivent rester non recouverts par l'élément de plaque supérieur. L'avantage de cette solution est qu'après découpe, le côté du composant qui ne comporte pas de plots apparents ne comporte pas de partie de deuxième plaque en surplomb au-dessus de la première plaque. Cependant, on notera qu'on peut parfois préférer avoir un surplomb dans le cas où on souhaite prendre un contact également sur la face inférieure de la plaque supérieure (sous le surplomb).

La figure 8 représente le composant qui en résulte après découpe lorsque la ligne LH'ₙ est superposée à la ligne LDₙ.

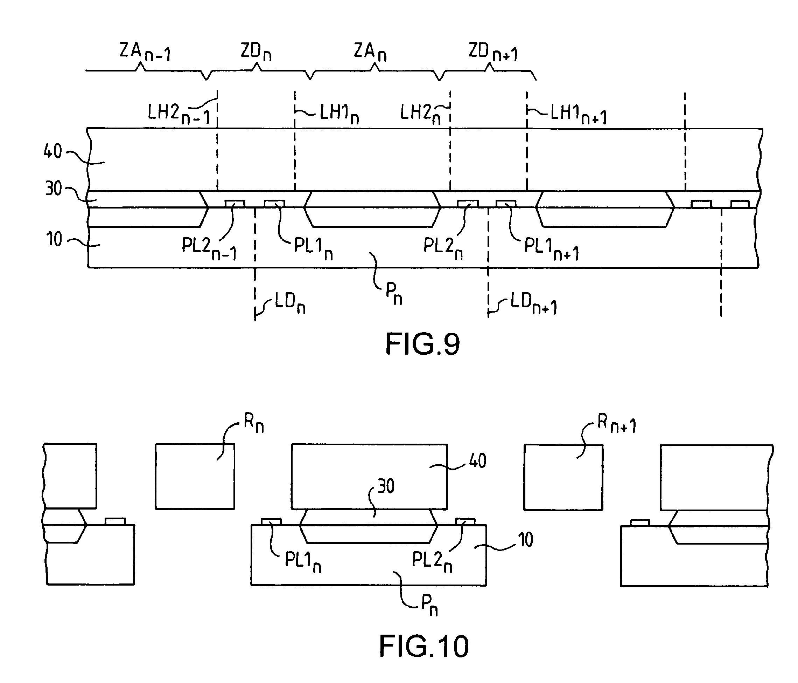

La figure 9 représente la tranche et la plaque superposées dans le cas où la puce comporte des plots sur deux côtés opposés, conformément à la représentation de la figure 1b ; les plots sont désignés par PL1ₙ pour le côté gauche de la puce Pₙ et par PL2ₙ pour le côté droit. Dans ce cas, le chemin de découpe ZDₙ entre la puce Pₙ et la puce Pₙ₋₁, qui s'étend encore dans tout l'espace séparant la zone active de la première puce et la zone active de la deuxième puce, s'étend à la fois au-dessus de plots PL2ₙ₋₁ de la puce Pₙ₋₁ et au-dessus de plots PL1ₙ de la puce adjacente Pₙ₋₁.

La ligne de découpe LDₙ de la tranche entre les puces Pₙ et Pₙ₋₁ passe dans le chemin de découpe ZDₙ entre le plot PL2ₙ₋₁ de la puce Pₙ₋₁ et le plot PL1ₙ de la puce Pₙ.

Pour définir la découpe de la plaque supérieure 40, il y a cette fois deux lignes de découpe parallèles et distinctes, respectivement une ligne LH1ₙ et une ligne LH2ₙ. La première passe dans le chemin de découpe entre la zone active ZAₙ de la puce Pₙ et un plot PL1ₙ de cette même puce ; la deuxième s'étend dans le même chemin de découpe ZDₙ entre le plot PL2ₙ₋₁ de la puce Pₙ₋₁ et la zone active ZAₙ₋₁ de la même puce. Les lignes de découpe LH1ₙ et LH2ₙ ne sont ni l'une ni l'autre superposées aux lignes de découpe LDₙ ou LDₙ₊₁ de la plaque inférieure.

Comme dans les explications relatives aux figures 3 et 4, le chemin de découpe est formé à la suite de l'opération de planarisation, par enlèvement local de la couche de planarisation 30 dans tout le chemin de découpe, ce qui d'une part crée un renfoncement de la surface de la tranche dans tout le chemin, et d'autre part dénude les plots de contact. Lors du collage par adhérence moléculaire, la quasi-totalité de la plaque adhère fortement à la tranche ; dans les chemins de découpe il n'y a pas d'adhérence entre la plaque et la tranche.

Lorsque la tranche est découpée le long des chemins de découpe, en principe d'abord par le haut puis par le bas, la double découpe du haut engendre un déchet qui est la partie de plaque située entre les deux lignes de découpe LH1 et LH2 du même chemin de découpe.

La figure 10 représente les structures à deux éléments après l'opération de découpe. La plaquette de verre qui recouvre chaque puce ne recouvre pas les plots de contact, ni d'un côté ni de l'autre et elle ne déborde de la puce ni à droite ni à gauche ; le déchet ou résidu Rₙ constitué par la portion de plaque de verre située entre les lignes de découpe LH2ₙ₋₁ et LH1ₙ est évacué lors d'une opération de nettoyage après découpe. Le déchet de verre n'adhère pas à la tranche semiconductrice puisqu'il provient entièrement de la zone située entre les deux lignes de découpe qui sont elles-mêmes entièrement situées dans le chemin de découpe non adhérent.

Si la puce comporte des plots sur trois côtés seulement (cas de la figure 1 b), on comprendra que la découpe sera faite conformément à la figure 4 pour les chemins de découpe en colonne et conformément à la figure 9 pour les chemins de découpe en ligne. Sur trois côtés, la plaquette ne déborde pas de la puce afin de laisser les plots accessibles ; sur le quatrième côté, elle peut déborder. Si la puce comporte des plots sur quatre côtés, la découpe sera faite conformément à la figure 9 pour les directions de découpe en ligne et pour les directions de découpe en colonne, et la plaquette ne débordera de la puce sur aucun des quatre côtés.

Lorsqu'il n'y a pas de plots sur l'un de deux côtés opposés (cas de la figure 1a et des figures 3 à 5), on peut souhaiter cependant que la plaquette de verre ne déborde pas de la puce contrairement à ce qui apparaît sur la figure 5. Dans ce cas, il suffit d'adopter une découpe de même type qu'aux figures 9 et 10, c'est-à-dire une double découpe de la plaque de verre dans le même chemin de découpe, laissant un résidu Rₙ. Par rapport à la figure 4, une deuxième ligne de découpe de la plaque de verre est prévue, analogue à la ligne de découpe LH2ₙ₋₁ de la figure 9 mais de préférence superposée à la ligne de découpe LDₙ, ce qui élimine le surplomb.

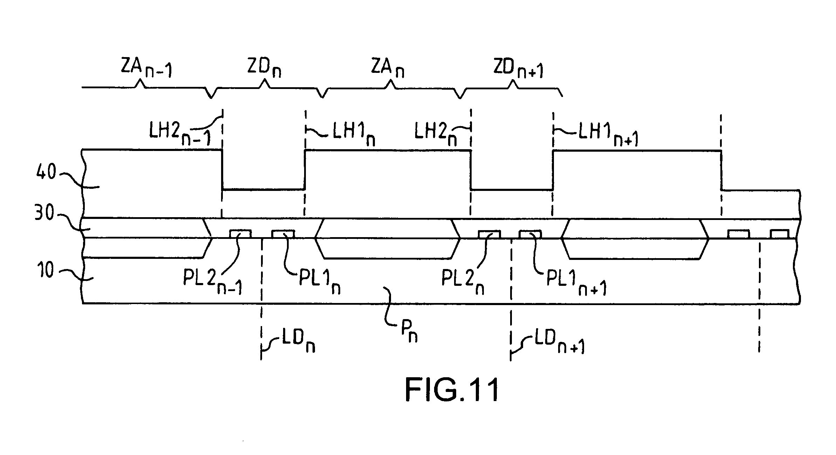

Dans le cas où la puce comporte des plots sur deux côtés opposés, conformément à la figure 9 et à la figure 10, on peut aussi adopter une découpe de la plaque supérieure par un trait de découpe large à la manière de ce qui est fait à la figure 7 : dans ce cas, au lieu d'avoir deux lignes de découpe fines voisines LH1ₙ et LH2ₙ₋₁, on utilise un seul trait de découpe large dont un bord est constitué par la ligne LH1ₙ et un autre bord est constitué par la ligne LH2ₙ₋₁. La figure 11 représente l'amorce de découpe qui résulte du sciage selon un trait de découpe large. La découpe enlève la matière au-dessus des plots PL2ₙ₋₁ et PL1ₙ simultanément. Le composant qui résulte de cette découpe est le même qu'à la figure 10.

D'une manière générale, la découpe se fait au laser ou à la scie. Elle est de préférence linéaire sur toute la tranche, les chemins de découpe étant des bandes longitudinales entre des lignes et des colonnes de puces individuelles. On peut effectuer la découpe d'abord par le haut ou d'abord par le bas. En pratique on peut procéder de la manière suivante : la première découpe est faite par la face supérieure de la plaque transparente 40, sur une profondeur qui correspond à l'épaisseur de la plaque 40 ou légèrement inférieure ; puis la découpe est effectuée par la face inférieure de la tranche semiconductrice, sur une profondeur qui correspond à une épaisseur égale ou légèrement inférieure à l'épaisseur de la tranche 10 ; dans le cas où une partie d'épaisseur non coupée subsiste sur la plaque ou sur la tranche, on termine la séparation en cassant la plaque et la tranche le long des lignes de découpe pour former des puces individuelles.

Dans ce qui précède on a considéré que le collage de la plaque et de la tranche se faisait par adhésion moléculaire car c'est la manière préférée de faire le collage ; en effet, d'une part l'adhérence est forte du fait de la grande planéité des surfaces et du fait que la quasi-totalité des surfaces en regard sont en contact direct, seuls des chemins de découpe étroits étant hors de contact direct ; et d'autre part le procédé est extrêmement propre puisque aucune matière de collage ne risque de polluer la surface de la tranche semiconductrice. La mise en contact des plaques est en général suivie d'un recuit qui complète l'adhérence.

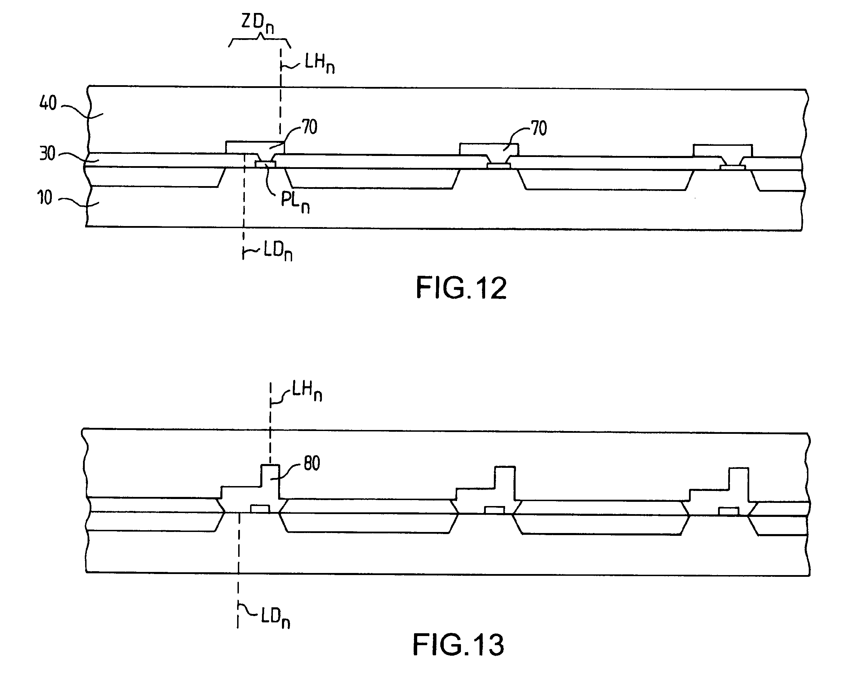

Lors de l'opération de découpe de la plaque 40, il faut faire attention que le laser ou la scie n'endommage pas la surface de la puce puisque la ligne de découpe se situe au-dessus d'une partie active de la puce. C'est pourquoi, même si le collage est fait par adhésion moléculaire, il est préférable de ménager dans la plaque des renfoncements importants (comme sur la figure 12, par exemple de plusieurs dizaines de micromètres de profondeur) au-dessus des chemins de découpe. La profondeur de coupe peut alors être réglée de manière qu'il n'y ait aucun risque que l'outil de coupe atteigne la tranche semiconductrice. Ceci est particulièrement utile lorsqu'on utilise une découpe avec un trait de découpe large comme aux figures 7 et 11.

Il est possible aussi de combiner des renfoncements peu profonds ayant pour but d'éviter une adhérence dans les chemins de découpe et des renfoncements plus profonds dans la plaque 40, ayant pour but d'éviter l'endommagement de la surface supérieure de la tranche 10 par l'outil de coupe ; les renfoncements plus profonds 80 sont alors localisés à l'endroit des lignes de découpe de la plaque de verre 40. La figure 13 représente un exemple de configuration de la plaque de verre avec des renfoncements à double profondeur dans les chemins de découpe. S'il y a deux lignes de découpe dans la plaque 40 dans le même chemin de découpe, il y a deux renfoncements profonds. La profondeur peut-être de plusieurs dizaines de micromètres.

Les renfoncements sont faits par photolithogravure ou par usinage mécanique ou usinage par laser, selon la profondeur désirée. Lors de la mise en place de la plaque supérieure sur la plaque inférieure, on aligne les plaques de manière que les renfoncements soient correctement localisés par rapport aux chemins de découpe. L'alignement est particulièrement simple dans le cas où la plaque supérieure est transparente.

On a ainsi décrit l'invention plus en détail dans le cas de la protection d'un capteur d'image par une plaquette de verre transparente. L'invention est applicable aussi à toutes sortes d'autres structures à deux éléments superposés. La plaque supérieure 40 pourrait être une plaque du même matériau que la tranche 10 dans des applications où la transparence de la plaque à la lumière visible n'est pas un paramètre décisif mais où il serait important que les coefficients de dilatation soient les mêmes et où il serait important aussi que les traitements effectués sur la plaque supérieure soient de même nature que ceux qui sont faits sur la plaque inférieure.

La plaquette peut aussi être une plaquette de fibres optiques.

Dans le cas de la radiologie, l'élément de structure supérieur peut comporter une structure scintillatrice convertissant les rayons X en une image lumineuse détectable par le capteur d'image (élément de structure inférieur). Cette structure scintillatrice peut être associée à une galette de fibres optiques juxtaposées, orientées perpendiculairement à la surface du capteur ; cette galette est alors recouverte d'une couche de matériau scintillateur.

La plaque de verre peut être remplacée par une plaque de silice fondue, ou d'autres matériaux dépendant de l'application envisagée. Des matériaux piézoélectriques peuvent par exemple être prévus pour des applications piézoélectriques.

## Revendications

1. Procédé de fabrication collective de structures à deux éléments superposés collés l'un à l'autre, à partir de deux plaques (10, 40) dont l'une comprend un réseau de premiers éléments sur lesquels doivent être collés des deuxièmes éléments appartenant à la deuxième plaque, la première plaque comportant des éléments de circuiterie électronique protégés par une couche de protection isolante, le procédé comprenant les opérations suivantes :
- collage de la face inférieure de la deuxième plaque (40) sur la face supérieure de la première plaque (10), sur la majeure partie de leurs surfaces respectives, en excluant du collage des zones dites chemins de découpe (ZDₙ) formées par gravure de renfoncements dans la couche de protection isolante de la première plaque ;
- découpe des plaques en structures individuelles à deux éléments superposés comprenant un élément de plaque inférieur et un élément de plaque supérieur, les opérations de découpe comprenant au moins une découpe d'un élément de la deuxième plaque (40) par le côté de sa face supérieure selon une première ligne de découpe (LHₙ ; LH1ₙ) passant le long d'un chemin de découpe (ZDₙ), et une découpe de l'élément de la première plaque (10), situé sous l'élément de la deuxième plaque, par le côté de sa face inférieure selon une deuxième ligne de découpe (LDₙ) passant le long du même chemin de découpe mais non superposée à la première ligne de découpe, de sorte qu'une partie de l'élément de plaque inférieur, située entre les deux lignes de découpe, ne soit pas recouverte par l'élément de plaque supérieur.

2. Procédé selon la revendication 1, **caractérisé en ce que** les opérations de découpe comportent une découpe de la deuxième plaque par sa face supérieure selon une troisième ligne de découpe (LH2ₙ₋₁) passant dans le même chemin de découpe (ZDₙ) et non superposée à la première et à la deuxième lignes de découpe, la partie située entre les première et troisième lignes de découpe constituant un déchet (Rₙ) ne faisant pas partie des structures superposées à deux éléments résultant du découpage des plaques.

3. Procédé selon la revendication 1, **caractérisé en ce que** la découpe de la deuxième plaque est effectuée avec une largeur de trait de découpe plus grande que la largeur de découpe de la première plaque, un bord du trait de découpe plus large constituant la ligne de découpe de la deuxième plaque, non superposée à la ligne de découpe de la première plaque.

4. Procédé selon l'une des revendications 1 à 3, **caractérisé en ce que** l'élément de plaque inférieur est une puce de circuit intégré, et la partie de l'élément de plaque inférieur non recouverte par l'élément de plaque supérieur comprend au moins un contact électrique (PLₙ) d'accès à des circuits électroniques formés sur la puce, ce contact étant situé sur la face supérieure de l'élément de plaque inférieur.

5. Procédé selon l'une des revendications 1 à 4, **caractérisé en ce que** le collage des plaques l'une sur l'autre est un collage direct, notamment un collage par adhérence moléculaire entre la face supérieure plane de la première plaque et la face inférieure plane de la deuxième plaque, les renfoncements empêchant localement l'adhérence.

6. Procédé selon l'une des revendications précédentes, **caractérisé en ce que** l'élément de plaque supérieur est un élément de protection de l'élément de plaque inférieur.

7. Procédé selon l'une des revendications précédentes, **caractérisé en ce que** la plaque supérieure est une plaque transparente, notamment une plaque de verre ou de silice fondue.

8. Procédé selon l'une des revendications précédentes, **caractérisé en ce que** la plaque supérieure comporte un réseau d'éléments optiques individuels, chaque élément optique correspondant à une puce de circuit intégré respective formée dans la plaque inférieure.

9. Procédé selon la revendication 8, **caractérisé en ce que** l'élément de plaque inférieur est un capteur d'image ou un afficheur d'image et l'élément de plaque supérieur est une structure optique associée à ce capteur.

10. Procédé selon la revendication 9, **caractérisé en ce que** la structure à deux éléments superposés est un capteur d'image radiologique, l'élément de plaque supérieur comportant une galette de fibres et/ou une structure scintillatrice convertissant les rayons X en une image lumineuse détectable par le capteur d'image.

11. Procédé selon l'une des revendications précédentes, **caractérisé en ce que** les structures à deux éléments superposés sont des structures micro-usinées de type MEMS ou MOEMS combinant des fonctions électroniques et des fonctions mécaniques et/ou optiques.

## Claims

1. Process for the collective fabrication of structures consisting of two superposed elements that are bonded together, starting from two plates (10, 40), one of which includes an array of first elements to which second elements belonging to the second plate have to be bonded, the first plate including electronic circuitry elements protected by an insulating protective layer, the process comprising the following operations:
- the lower face of the second plate (40) is bonded to the upper face of the first plate (10), over the major portion of their respective surfaces, but not bonding the zones called "dicing paths" (ZDₙ) that are formed by etching indentations in the insulating protective layer on the first plate; and
- the plates are diced into individual structures consisting of two superposed elements, comprising a lower plate element and an upper plate element, the dicing operations comprising at least dicing of an element of the second plate (40) via its topside along a first dicing line (LHₙ; LH1ₙ) passing along a dicing path (ZDₙ), and dicing of an element of the first plate (10), located beneath the element of the second plate, via the underside along a second dicing line (LDₙ) passing along the same dicing path but not superposed with the first dicing line, so that a portion of the lower plate element, lying between the two dicing lines, is not covered by the upper plate element.

2. Process according to Claim 1, **characterized in that** the dicing operations comprise dicing the second plate via its upper side along a third dicing line (LH2ₙ₋₁) passing through the same dicing path (ZDₙ) but not superposed with the first and second dicing lines, the portion lying between the first and third dicing lines constituting scrap (Rₙ) not forming part of the two-element superposed structures that result from dicing the plates.

3. Process according to Claim 1, **characterized in that** the dicing of the second plate is performed with a kerf width larger than the dicing width of the first plate, one edge of the wider kerf constituting the dicing line of the second plate, which is not superposed with the dicing line of the first plate.

4. Process according to one of Claims 1 to 3, **characterized in that** the lower plate element is an integrated circuit chip and the portion of the lower plate element not covered by the upper plate element includes at least one electrical contact (PLₙ) for access to the electronic circuits formed on the chip, this contact being located on the upper face of the lower plate element.

5. Process according to one of Claims 1 to 4, **characterized in that** the bonding of the wafers to each other is direct bonding, especially molecular adhesion between the planar upper face of the first plate and the planar lower face of the second plate, the indentations preventing local adhesion.

6. Process according to one of the preceding claims, **characterized in that** the upper plate element is an element for protecting the lower plate element.

7. Process according to one of the preceding claims, **characterized in that** the upper plate is a transparent plate, especially a glass or fused silica plate.

8. Process according to one of the preceding claims, **characterized in that** the upper plate includes an array of individual optical elements, each optical element corresponding to a respective integrated circuit chip formed in the lower plate.

9. Process according to Claim 8, **characterized in that** the lower plate element is an image sensor or image display, and the upper plate element is an optical structure associated with this sensor.

10. Process according to Claim 9, **characterized in that** the structure consisting of two superposed elements is a radiological image sensor, the upper plate element including a fiber wafer and/or a scintillator structure that converts X-rays into a light image which can be detected by the image sensor.

11. Process according to one of the preceding claims, **characterized in that** the structures consisting of two superposed elements are micromachined structures of the MEMS or MOEMS type which combine electronic functions and mechanical and/or optical functions.

## Patentansprüche

1. Verfahren zur gemeinsamen Herstellung von Strukturen mit zwei übereinanderliegenden Elementen, die aneinander geklebt werden, ausgehend von zwei Platten (10, 40), von denen eine ein Netz von ersten Elementen aufweist, auf die zweite Elemente geklebt werden müssen, die zur zweiten Platte gehören, wobei die erste Platte durch eine isolierende Schutzschicht geschützte Elemente elektronischer Schaltungen aufweist, wobei das Verfahren die folgenden Arbeitsgänge aufweist:
- Kleben der Unterseite der zweiten Platte (40) auf die Oberseite der ersten Platte (10) auf den Hauptabschnitt ihrer jeweiligen Flächen, wobei Bereiche, die Schnittwege (ZDₙ) genannt werden, die durch Gravur von Einrückungen in die isolierende Schutzschicht der ersten Platte gebildet werden, vom Kleben ausgeschlossen werden;
- Schnitt der Platten in einzelne Strukturen mit zwei übereinanderliegenden Elementen, die ein unteres Plattenelement und ein oberes Plattenelement aufweisen, wobei die Schnittarbeitsgänge mindestens einen Schnitt eines Elements der zweiten Platte (40) von der Seite ihrer Oberseite gemäß einer ersten Schnittlinie (LHₙ, LH1ₙ) entlang eines Schnittwegs (ZDₙ) und einen Schnitt des Elements der ersten Platte (10), das sich unter dem Element der zweiten Platte befindet, von der Seite ihrer Unterseite gemäß einer zweiten Schnittlinie (LDₙ) entlang des gleichen Schnittwegs, aber nicht mit der ersten Schnittlinie übereinanderliegend, umfassen, derart, dass ein Abschnitt des unteren Plattenelements, der sich zwischen den zwei Schnittlinien befindet, nicht durch das obere Plattenelement bedeckt wird.

2. Verfahren nach Anspruch 1, **dadurch gekennzeichnet, dass** die Schnittarbeitsgänge einen Schnitt der zweiten Platte von ihrer Oberseite gemäß einer dritten Schnittlinie (LH2ₙ₋₁) über den gleichen Schnittweg (ZDₙ) und nicht mit der ersten und der zweiten Schnittlinie übereinanderliegend umfassen, wobei der Abschnitt, der sich zwischen der ersten und der dritten Schnittlinie befindet, ein Abfallprodukt (Rₙ) bildet, das nicht Teil der übereinanderliegenden Strukturen mit zwei Elementen ist, die aus dem Schnitt der Platten hervorgehen.

3. Verfahren nach Anspruch 1, **dadurch gekennzeichnet, dass** der Schnitt der zweiten Platte mit einer Schnittbreite durchgeführt wird, die größer ist als die Schnittbreite der ersten Platte, wobei ein Rand der breiteren Schnittbreite die Schnittlinie der zweiten Platte bildet, die nicht mit der Schnittlinie der ersten Platte übereinanderliegt.

4. Verfahren nach einem der Ansprüche 1 bis 3, **dadurch gekennzeichnet, dass** das untere Plattenelement ein Chip einer integrierten Schaltung ist und der Abschnitt des unteren Plattenelements, der nicht durch das obere Plattenelement bedeckt ist, mindestens einen elektrischen Kontakt (PLₙ) zum Zugang zu elektronischen Schaltungen aufweist, die auf dem Chip gebildet werden, wobei sich dieser Kontakt auf der Oberseite des unteren Plattenelements befindet.

5. Verfahren nach einem der Ansprüche 1 bis 4, **dadurch gekennzeichnet, dass** das Kleben der Platten aufeinander ein direktes Kleben, insbesondere ein Kleben durch molekulare Adhäsion zwischen der ebenen Oberseite der ersten Platte und der ebenen Unterseite der zweiten Platte ist, wobei die Einrückungen die Adhäsion lokal verhindern.

6. Verfahren nach einem der vorhergehenden Ansprüche, **dadurch gekennzeichnet, dass** das obere Plattenelement ein Schutzelement des unteren Plattenelements ist.

7. Verfahren nach einem der vorhergehenden Ansprüche, **dadurch gekennzeichnet, dass** die obere Platte eine transparente Platte, insbesondere eine Platte aus Glas oder Quarzgut, ist.

8. Verfahren nach einem der vorhergehenden Ansprüche, **dadurch gekennzeichnet, dass** die obere Platte ein Netz von einzelnen optischen Elementen aufweist, wobei jedes optische Element einem jeweiligen in der unteren Platte gebildeten Chip einer integrierten Schaltung entspricht.

9. Verfahren nach Anspruch 8, **dadurch gekennzeichnet, dass** das untere Plattenelement ein Bildsensor oder eine Bildanzeigeeinrichtung ist und das obere Plattenelement eine diesem Sensor zugehörige optische Struktur ist.

10. Verfahren nach Anspruch 9, **dadurch gekennzeichnet, dass** die Struktur mit zwei übereinanderliegenden Elementen ein Röntgenbildsensor ist, wobei das obere Plattenelement eine Faserplatte und/oder eine szintillierende Struktur aufweist, die Röntgenstrahlen in ein Lichtbild umwandelt, das durch den Bildsensor detektiert werden kann.

11. Verfahren nach einem der vorhergehenden Ansprüche, **dadurch gekennzeichnet, dass** die Strukturen mit zwei übereinanderliegenden Elementen mikrobearbeitete Strukturen des Typs MEMS oder MOEMS sind, die elektronische Funktionen und mechanische und/oder optische Funktionen kombinieren.
